Europäisches Patentamt

European Patent Office

Office européen des brevets

(11) Veröffentlichungsnummer: **0 064 569**
**B1**

(12) **EUROPÄISCHE PATENTSCHRIFT**

(45) Veröffentlichungstag der Patentschrift:
27.02.85

(51) Int. Cl.⁴: **G 11 C 8/00,** G 11 C 11/24, G 11 C 11/40

(21) Anmeldenummer: 81103660.7

(22) Anmeldetag: 13.05.81

(54) **Eingangsschaltung für einen monolithisch integrierten Halbleiterspeicher mit Feldeffekttransistoren.**

(43) Veröffentlichungstag der Anmeldung:
17.11.82 Patentblatt 82/46

(45) Bekanntmachung des Hinweises auf die Patenterteilung:
27.02.85 Patentblatt 85/9

(84) Benannte Vertragsstaaten:
DE FR GB IT

(56) Entgegenhaltungen:
DE - A - 2 935 121
GB - A - 2 056 807

IEEE JOURNAL OF SOLID-STATE CIRCUITS, Heft 11, Nr. 3, Juni 1976, NEW YORK (US) R. REMSHARDT et al.: "A High Performance Low Power 2048-Bit Memory Chip in MOSFET Technology and its Application", Seiten 352-359

(73) Patentinhaber: **IBM DEUTSCHLAND GMBH, Pascalstrasse 100, D-7000 Stuttgart 80 (DE)**
(84) Benannte Vertragsstaaten: **DE**

(73) Patentinhaber: **International Business Machines Corporation, Old Orchard Road, Armonk, N.Y. 10504 (US)**
(84) Benannte Vertragsstaaten: **FR GB IT**

(72) Erfinder: **Haug, Werner, Pontolser Strasse 43, D-7030 Böblingen (DE)**
Erfinder: **Clemen, Rainer, Maurener Weg 133, D-7030 Böblingen (DE)**

(74) Vertreter: **Neuland, Johannes, Dipl.-Ing., Schönaicher Strasse 220, D-7030 Böblingen (DE)**

# Beschreibung

Die Erfindung bezieht sich auf eine Eingangsschaltung für einen monolithisch integrierten Halbleiterspeicher mit Feldeffekttransistoren, die zur Verstärkung des bekannten Bootstrap-Effektes eine dynamische Vorladeschaltung enthält.

Wegen ihres geringen Platz- und Leistungsbedarfs gegenüber monolithisch integrierten Speicherschaltungen aus Bipolartransistoren haben solche aus Feldeffekttransistoren weite Verbreitung als Hauptspeicher moderner programmgesteuerter Datenverarbeitungsanlagen gefunden.

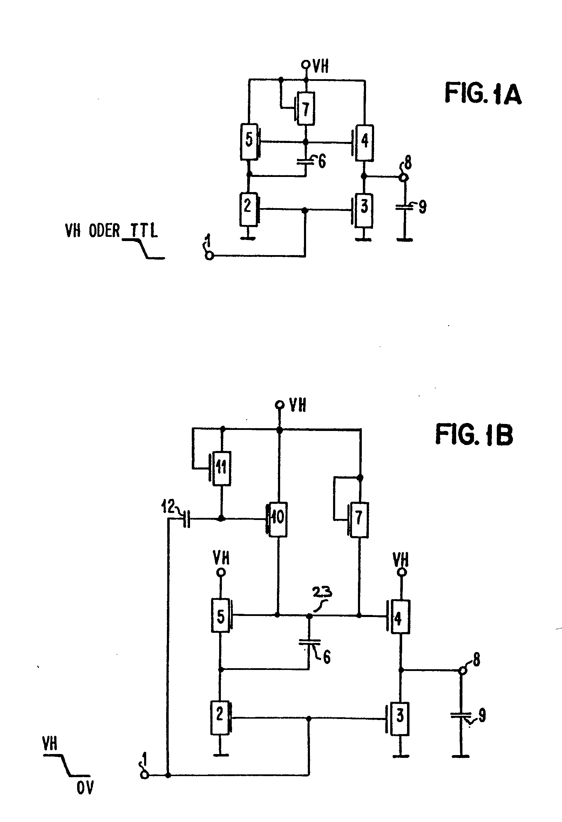

Als Eingangsschaltung für einen aus Feldeffekttransistoren, im folgenden kurz als FET bezeichnet, aufgebauten monolithisch integrierten Halbleiterspeicher dient vielfach eine den sogenannten Bootstrap-Effekt ausnutzende Schaltung, wie sie aus der DE-OS Nr. 2243671 bekannt ist. Eine derartige Schaltung, die als Inverter wirkt und deren Schaltbild in Fig. 1A dargestellt ist, liefert bei einem abfallenden Eingangspegel einen rasch auf den Wert der Betriebsspannung VH ansteigenden Ausgangspegel.

Die Ansteuerung von FET-Speichern erfolgt häufig durch digitale Schaltungen, die aus bipolaren Transistoren aufgebaut sind, weil deren Schaltgeschwindigkeit grösser ist als die von Feldeffekttransistoren.

Ein für digitale Schaltungen mit Bipolartransistoren typisches Spannungspegelschema ist das sogenannte TTL-Pegelschema. Dabei ist vereinbart, dass der eine Binärzustand, z.B. die logische Null durch einen Spannungswert im Bereich von 0 bis 0,8 V, der andere Binärzustand, z.B. die logische Eins, durch einen Spannungswert im Bereich von 2,0 V bis zur maximalen Betriebsspannung von z.B. 5,5 V repräsentiert wird. Demgegenüber liegen der für FET-Schaltungen typische obere Ansteuerpegel sowie die Betriebsspannung deutlich höher, z.B. bei VH = 8,5 V. Daraus folgt aber, dass ein MOS-Feldeffekttransistor mit einem typischen Schwellspannungswert von 1,5 V, der im ungünstigsten Fall nur mit einem oberen Eingangspegel von 2 V angesteuert wird, nur relativ schwach leitet. Ein so angesteuerter FET ist auch in seinem Leitzustand noch relativ hochohmig. Er kann daher eine von ihm verlangte Auf- oder Entladung eines weiteren Schaltungsknotens, einer Kapazität od. dgl. nur vergleichsweise langsam durchführen. Aus diesem Grunde werden oft an den Nahtstellen zwischen Bipolar- und FET-Bausteinen separate Pegelumsetzer benützt.

Die Schaltung nach Fig. 1A wird vorzugsweise mit FET-Pegeln und bei entsprechend grösser dimensionierten FET 2 und 3 auch mit TTL-Pegeln angesteuert. Der Bootstrap-Inverter wird durch die FET 2 bis 7 und den Bootstrap-Kondensator 6 gebildet. Die miteinander verbundenen Gate-Elektroden der FET 4 und 5 werden über den zu einem Zweipol verdrahteten FET 7 auf den um die Schwellenspannung VT des FET 7 verminderten Wert der Betriebsspannung VH vorgeladen. Beim Sperren der beiden Eingangs-FET 2 und 3 wird das Potential beider Elektroden des Kondensators 6 über den FET 5 rasch hochgezogen (*bootstrapping*), weil ihm die Eingangskapazität 9 der an den Ausgang 8 der Inverterschaltung angeschlossenen Schaltung nicht parallel liegt.

Zum besseren Verständnis der Erfindung werden zunächst kurz Aufbau und Wirkungsweise der Schaltung nach Fig. 1B betrachtet. Diese Schaltung besteht aus dem aus der DE-OS Nr. 2243671 bekannten Bootstrap-Inverter nach Fig. 1A und einer diesem hinzugefügten dynamischen Vorladeschaltung zur rascheren Aufladung der Lastkapazität 9. Der Bootstrap-Inverter wird durch die FET 2 bis 7 und den Bootstrap-Kondensator 6 gebildet, während die dynamische Vorladeschaltung aus dem FET 10 und 11 sowie dem Kondensator 12 aufgebaut ist.

Durch die aus den FET 10 und 11 sowie dem Kondensator 12 bestehende dynamische Vorladeschaltung wird erreicht, dass die miteinander verbundenen Gate-Elektroden der FET 4 und 5 über den FET 7 nicht nur auf den um die Schwellenspannung VT des FET 7 verminderten Wert der Betriebsspannung VH vorgeladen werden, sondern beim Eintreffen einer ansteigenden Flanke des Eingangssignals auf den vollen Wert der Betriebsspannung VH. Bei Eintreffen der ansteigenden Flanke des Eingangssignals, die von dem Kondensator 12 an das auf die Spannung VH-VT vorgeladene Gate des FET 10 übertragen wird, steigt dessen Gate-Potential etwa auf den Wert 2 VH-VT an, so dass es ein Source-Potential 23 und damit das Potential der miteinander verbundenen Gate-Elektroden der FET 4 und 5 den Wert VH annimmt. Durch dieses Vorladen der Gate-Elektroden auf den vollen Wert VH der Betriebsspannung wird bei abfallender Flanke des Eingangssignals und damit beim Sperren der Schalt-FET 2 und 3 und dem Potentialanstieg des Bootstrap-Kondensators 6 über den FET 5 das Gate-Potential der beiden Last-FET 4 und 5 so stark erhöht, dass die Lastkapazität 9 noch rascher auf den vollen Wert der Betriebsspannung VH aufgeladen wird, als das ohne Verwendung der dynamischen Vorladeschaltung der Fall wäre.

Die vorteilhafte Schaltung nach Fig. 1B weist jedoch den Nachteil auf, dass sie FET-Pegel erfordert. Bei einer Ansteuerung mit den niedrigen TTL-Pegeln wird nämlich der Knoten 23 wegen des kleinen TTL-Potentialhubes von 2 - 0,8 = 1,2 V durch die Vorladeschaltung nicht auf VH aufgeladen und wird somit wertlos. Die Aufladung des Knotens 23 erfolgt also allein durch den Aufladetransistor T7 auf maximal nur VH-VT, wie in der Schaltung nach Fig. 1A.

Da die Schaltung nach Fig. 1B als Eingangsschaltung für einen mit TTL-Pegeln anzusteuernden FET-Speicher nicht geeignet ist, will die Erfindung hier Abhilfe schaffen. Die Erfindung, wie sie im Anspruch 1 gekennzeichnet ist, löst die Aufgabe, eine Eingangsschaltung für einen FET-Speicher anzugeben, die trotz Ansteuerung mit TTL-Pegeln ein rasches Aufladen des Ausgangsknotens 8 durch eine Voraufladung der Gate der FET 4 und 5 auf die Betriebsspannung VH gewährleistet.

Die durch die Erfindung erreichten Vorteile sind im wesentlichen darin zu sehen, dass ein bipolarer Pegelumsetzer, der die TTL-Pegel in zur Ansteuerung von FET-Speichern benötigte Pegel umsetzt, entfallen kann.

Im folgenden wird die Erfindung in Verbindung mit den Zeichnungen näher beschrieben, von denen zeigen:

Fig. 1A das Schaltbild einer mit FET- oder TTL-Pegeln arbeitenden Eingangsschaltung für einen FET-Speicher, die aus einer bekannten Inverterschaltung besteht;

Fig. 1B das Schaltbild einer mit FET-Pegeln arbeitenden Eingangsschaltung für einen FET-Speicher, die aus einer bekannten Inverterschaltung besteht und durch eine dynamische Vorladeschaltung ergänzt wurde;

Fig. 2 das Schaltbild einer erfindungsgemässen Eingangsschaltung für einen FET-Speicher, auf die zwei weitere, als Blockschaltbild dargestellte Inverterstufen folgen;

Fig. 3 ein Impulsdiagramm für die Eingangsschaltung nach Fig. 2;

Fig. 4 das Schaltbild eines zweiten Ausführungsbeispieles gemäss der Erfindung, und

Fig. 5 ein Impulsdiagramm für die Eingangsschaltung nach Fig. 4.

Bei den in den Fig. 1A, 1B, 2 und 4 dargestellten Schaltbildern sind übliche N-Kanal-MOS-FET vorausgesetzt, deren Betriebsspannung VH in typischen Fällen etwa 8,5 V beträgt. Die Erfindung kann jedoch in gleicher Weise auch mit FET des anderen Leitungstyps und einer entsprechend geänderten Betriebsspannung realisiert werden.

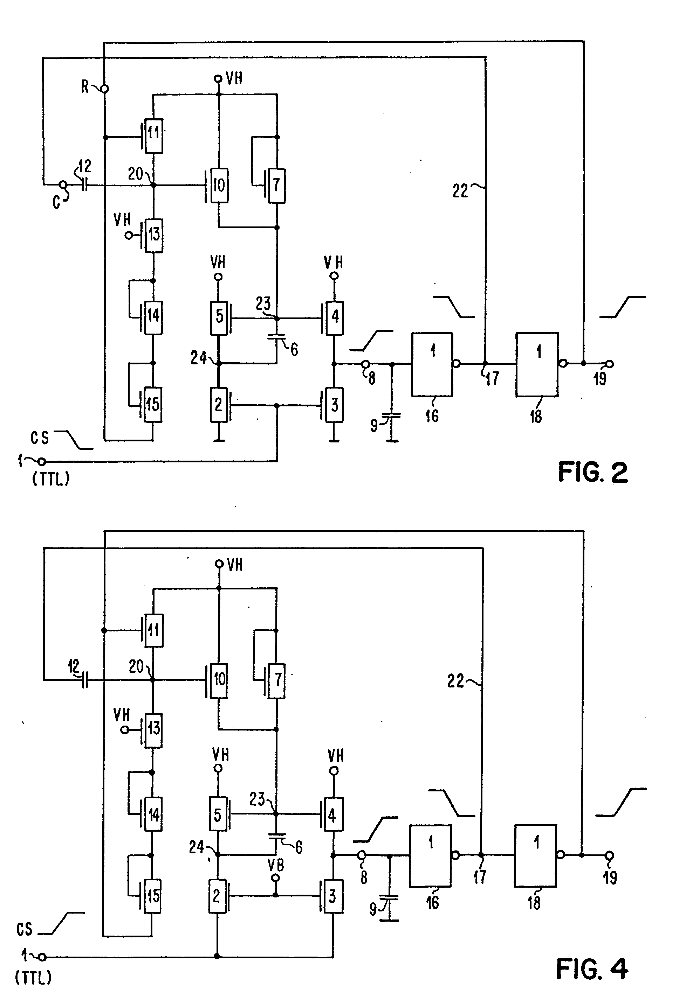

Fig. 2 zeigt das Schaltbild eines ersten Ausführungsbeispiels der Erfindung. Diese mit TTL-Pegeln ansteuerbare Eingangsschaltung für einen FET-Speicher stellt eine Abwandlung der Schaltung nach Fig. 1B dar. Bauelemente der Schaltung nach Fig. 2, die denen der Schaltung nach Fig. 1B entsprechen, sind mit den gleichen Bezugszeichen versehen. Da die aus den FET 10 und 11 sowie dem Kondensator 12 bestehende dynamische Vorladeschaltung für die miteinander verbundenen Gate-Elektroden der FET 4 und 5 zu ihrer Funktion eine Ansteuerung mit FET-Pegeln erfordert, ist bei der Schaltung nach Fig. 2 die erste Elektrode des Kondensators 12 nicht mit der Eingangsklemme 1 verbunden, sondern mit dem Ausgang 17 eines nur in Blockform dargestellten und auf die Eingangsschaltung für den FET-Speicher folgenden Inverters 16. Ferner ist in Fig. 2 das Gate des Auflade-FET 11 nicht an den positiven Pol VH der Versorgungsspannung angeschlossen, sondern an den Ausgang 19 eines auf den Inverter 16 folgenden Inverters 18, der ebenfalls nur in Blockform dargestellt ist. Ausserdem ist der gemeinsame Verbindungspunkt 20 der zweiten Elektrode des Kondensators 12 mit der Source des Auflade-FET 11 und dem Gate des Last-FET 10 über die hochohmige Reihenschaltung der drei Entlade-FET 13, 14 und 15 an das mit dem Ausgang 19 des Inverters 18 verbundene Gate des FET 11 angeschlossen.

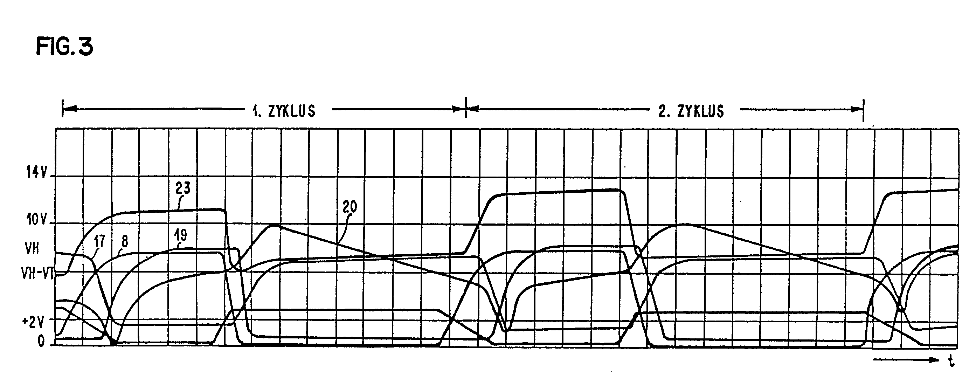

Die Wirkungsweise der Eingangsschaltung nach Fig. 2 wird in Verbindung mit den Impulsdiagrammen nach Fig. 3 beschrieben. Es wird davon ausgegangen, dass das der Eingangsklemme 1 der Eingangsschaltung zugeführte TTL-Signal (Fig. 3), das zuerst im Ruhezustand den hohen TTL-Pegel aufwies, jetzt den niedrigen Signalpegel annimmt. Dadurch sperren die bisher leitenden Schalt-FET 2 und 3, so dass der Ausgang 8 der Eingangsstufe, der bisher den niedrigen FET-Signalpegel aufwies, nun aufgrund der bekannten Wirkung des Bootstrap-Kondensators 6 rasch den hohen FET-Ausgangspegel annimmt. Beim Ansteigen des Potentials des Knotens 23 über den Wert VH infolge der Bootstrap-Wirkung des Kondensators 6 fliesst kein Strom über den FET 10 zum positiven Pol VH der Betriebsstromquelle. Dies würde nämlich der durch den Bootstrap-Kondensator 6 beim Ansteigen des Potentials des Knotens 24 bewirkten Spannungserhöhung am Knoten 23 entgegenwirken. Dadurch würde das Ausgangspotential des Ausgangs 8 langsamer ansteigen und nicht den vollen Wert der Betriebsspannungsquelle VH erreichen. Die FET 13, 14 und 15 und ihr Ansteuerimpuls 19, der in Gegenphase zum Eingangssignal ist, entladen das Gate 20 des FET 10 vor dem Abfall des Eingangssignals 1 auf ein Potential niedriger als VH-VT, so dass der FET 10 beim Anstieg des Potentials 23 über den Wert VH sicher gesperrt ist. Das Gate des FET 13 ist an den positiven Pol VH der Betriebsspannungsquelle angeschlossen, so dass dieser FET stets leitend ist. Die FET 14 und 15 sind durch Verbindung von Drain und Gate zu Zweipolen verdrahtet.

Die Eingangsschaltung nach Fig. 2 wird vorzugsweise als Pegelumsetzer in einem dynamischen FET-Speicherchip vorgesehen. Zum Beispiel kann das TTL-Chip-Selektionssignal CS an den Eingang 1 angelegt werden. Der längste CS-Zyklus liegt in der Grössenordnung von 100 µs, da ja das Speicherchip zur Auffrischung der dynamischen Speicherzellen laufend selektiert werden muss. Die Eingangsschaltung selbst wird also auch aufgefrischt. Zum Beispiel wird der Knoten 23 durch Leckströme in 100 µs nur unwesentlich unter den Wert VH entladen. Bei der Inbetriebnahme des Speichers ist allerdings die Vorladeschaltung noch unwirksam und der Knoten 23 wird allein durch den FET 7 auf einem Potential unwesentlich unter dem Wert VH-VT gehalten. Bei Beginn des ersten Zyklus steigt daher die Spannung am Ausgang 8 der Eingangsschaltung wegen des niedrigen Potentials VH-VT am Knoten 23 nur verzögert und langsam an. Am Ende des ersten Zyklus wird über die Vorladeschaltung, d.h. über den FET 10, der Knoten 23 auf das Potential VH aufgeladen. Im zweiten und allen folgenden Zyklen steigt jetzt die Ausgangsspannung kaum verzögert und sehr schnell an.

Fig. 3 zeigt ein Impulsdiagramm für die erfindungsgemässe Eingangsschaltung, das die Potentialverläufe an den verschiedenen Knoten der Schaltung wiedergibt. Aus dem Diagramm ist ersichtlich, dass nach dem ersten Zyklus die Anstiegszeit für das Potential des Ausgangs 8 etwa nur noch die Hälfte des Wertes beträgt, der im ersten Zyklus erreicht wird. Die Zykluszeit ist zu 360 Ns angenommen.

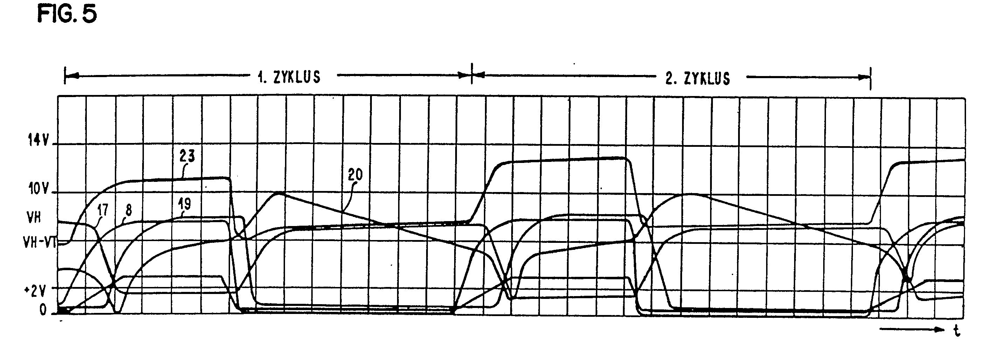

Fig. 4 zeigt das Schaltbild eines weiteren Ausführungsbeispieles der Erfindung. Es unterscheidet sich von dem nach Fig. 2 lediglich dadurch, dass die Schalttransistoren 2 und 3 an den miteinander verbundenen Source-Elektroden angesteuert werden, während ihren miteinander verbundenen Gate-Elektroden ein festes Vorspannungspotential VB zugeführt wird. Aufgrund dieser schaltungstechnischen Massnahme ist das Eingangssignal mit dem am Ausgang 8 erscheinenden Ausgangssignal in Phase. Weitere Unterschiede zum Schaltbild nach Fig. 2 sind nicht vorhanden. Auch die Wirkungsweise der Schaltung nach Fig. 4 entspricht der, die in Verbindung mit der Fig. 2 beschrieben wurde. Dies geht auch aus dem Impulsdiagramm nach Fig. 5 hervor, in dem lediglich das der Klemme 1 zugeführte TTL-Eingangssignal die entgegengesetzte Phasenlage aufweist, als das im Impulsdiagramm nach Fig. 3 der Fall ist.

Wie schon erwähnt, eignen sich die Schaltungen nach Fig. 2 und Fig. 4 vor allem als Pegelumsetzer und Signalverstärker für das Chip-Selektionssignal. Da letzteres in einem Speicherchip sehr stark kapazitiv belastet wird, werden die Inverter 16 und 18 nicht zusätzlich für die Erfindung benötigt, sondern sind ohnehin schon aus verstärkungstechnischen Gründen vorhanden.

## Patentansprüche

1. Eingangsschaltung für einen monolithisch integrierten Halbleiterspeicher aus Feldeffekttransistoren (FET) die mit TTL-Pegeln angesteuert wird und zur Pegelumsetzung den Bootstrap-Effekt ausnützt sowie eine dynamisch arbeitende, aus FET (7, 10, 11, 13 bis 15) und einem Kondensator (12) bestehende Vorladeschaltung enthält, die den Bootstrap-Knoten (23) der Eingangsschaltung auf die Betriebsspannung vorlädt, dadurch gekennzeichnet, dass die Eingangselektrode des Kondensators (12) der dynamisch arbeitenden Vorladeschaltung an den Ausgang (17) eines auf die Eingangsschaltung folgenden Inverters (16) angeschlossen ist, dass ein hochohmiger Entladezweig (FET 13, 14, 15) für den Knoten (20) der dynamisch arbeitenden Vorladeschaltung vorgesehen ist, an den weiterhin die zweite Kondensatorelektrode, das Gate des Ausgangs-FET (10) der Vorladeschaltung und die Source eines dessen Gate vorladenden FET (11) angeschlossen sind, und dass der zweite Anschluss des Entladezweiges zusammen mit dem Gate des Vorlade-FET (11) an den Ausgang (19) eines weiteren, auf den ersten folgenden Inverter (18) angeschlossen ist.

2. Eingangsschaltung nach Anspruch 1, dadurch gekennzeichnet, dass der Entladezweig aus der Reihenschaltung mehrerer FET (13, 14, 15) besteht, deren erster ständig leitend ist, während die übrigen als Last-FET ausgebildet sind, bei denen jeweils die Gate-Elektrode mit der Drain-Elektrode verbunden ist.

3. Eingangsschaltung nach den Ansprüchen 1 und 2, dadurch gekennzeichnet, dass sie als Inverter ausgebildet ist.

4. Eingangsschaltung nach den Ansprüchen 1 und 2, dadurch gekennzeichnet, dass sie als nichtinvertierende Eingangsschaltung ausgebildet ist.

5. Eingangsschaltung nach den Ansprüchen 1 bis 4, dadurch gekennzeichnet, dass sie aus N-Kanal-FET aufgebaut ist.

6. Eingangsschaltung nach den Ansprüchen 1 bis 4, dadurch gekennzeichnet, dass sie aus P-Kanal-FET aufgebaut ist.

## Claims

1. Input circuit for a monolithically integrated semiconductor storage with field effect transistors (FET) which is controlled with TTL levels and which for level conversion uses the bootstrap effect, and contains a dynamically operating charge-up circuit consisting of FET (7, 10, 11, 13 to 15) and a capacitor (12), and charges up the bootstrap node (23) of the input circuit to the operating voltage, characterised in that the input electrode of the capacitor (12) of the dynamically operating charge-up circuit is connected to the output (17) of an inverter (16) following the input circuit, that a highly resistive discharge branch (FET 13, 14, 15) is provided for the node (20) of the dynamically operating charge-up circuit, to which node are also connected the second capacitor electrode, the gate of the output FET (10) of the charge-up circuit, and the source of a FET (11) charging-up the gate of FET (10), and in that together with the gate of the charge-up FET (11) the second terminal of the discharge branch is connected to the output (19) of another inverter (18) following the first one.

2. Input circuit as claimed in Claim 1, characterised in that the discharge branch consists of the series connection of several FET (13, 14, 15) whose first one is continuously conductive, whereas the remaining ones are designed as load FET, with the respective gate electrode being connected to the drain electrode.

3. Input circuit as claimed in Claims 1 and 2, characterised in that it is designed as an inverter.

4. Input circuit as claimed in Claims 1 and 2, characterised in that it is designed as a non-inverting input circuit.

5. Input circuit as claimed in Claims 1 to 4, characterised in that it is designed of N-channel FET.

6. Input circuit as claimed in Claims 1 to 4, characterised in that it is designed of P-channel FET.

## Revendications

1. Circuit d'entrée pour une mémoire semiconductrice monolithique intégrée constituée de transistors à effet de champ, commandé par des niveaux TTL, qui exploite l'effet bootstrap pour convertir le niveau logique et comporte un circuit de préchargement dynamique constitué de transistors à effet de champ (7, 10, 11, 13 à 15) et un capaciteur (12), lequel circuit de préchargement applique la tension de fonctionnement au nœud bootstrap (23) dudit circuit d'entrée, caractérisé en ce que l'électrode d'entrée dudit capaciteur (12) du circuit de préchargement dynamique est reliée à l'entrée (17) d'un circuit inverseur (16) suivant ledit circuit d'entrée, en ce qu'il est prévu un dérivé de décharge à impédance élevée (FET 13, 14, 15) dudit nœud (20) du circuit de préchargement dynamique, lequel dérivé est aussi relié à la seconde électrode de capaciteur, à la porte du transistor à effet de champ de sortie (10) dudit circuit de préchargement et à la source d'un transistor à effet de champ qui applique une tension de préchargement à sa porte, et en ce que la seconde connexion dudit dérivé de décharge est relié ainsi que la porte dudit transistor à effet de champ de préchargement (11) à la sortie (19) d'un autre circuit inverseur (18) suivant ledit premier circuit inverseur.

2. Circuit d'entrée selon la revendication 1, caractérisé en ce que ledit dérivé de décharge est constitué par un montage en série de plusieurs transistors à effet de champ (13, 14, 15), où le premier de ces transistors à effet de champ est toujours conducteur, tandis que les autres transistors à effet de champ sont réalisés comme transistors à effet de champ de chargement, l'électrode de porte de chacun de ces transistors étant reliée à l'électrode de drain.

3. Circuit d'entrée selon les revendications 1 et 2, caractérisé en ce qu'il est réalisé comme circuit inverseur.

4. Circuit d'entrée selon les revendications 1 et 2, caractérisé en ce qu'il est réalisé comme circuit d'entrée non inverseur.

5. Circuit d'entrée selon les revendications 1 à 4, caractérisé en ce qu'il consiste en un transistor à effet de champ à canal N.

6. Circuit d'entrée selon les revendications 1 à 4, caractérisé en ce qu'il consiste en un transistor à effet de champ à canal P.

FIG. 1A

VH ODER TTL

FIG. 1B

VH

OV

**FIG. 2**

**FIG. 4**

FIG.3

1. ZYKLUS          2. ZYKLUS

14V

23

10V          20

VH

VH-VT          17    8    19

+2V

0

t

0 064 569

FIG. 5